# EUROPEAN PATENT APPLICATION

(11) **EP 2 660 880 A2**
(43) Date of publication of application: **06.11.2013**
(21) Application number: 13163696.1
(22) Date of filing: 15.04.2013
(51) Int. Cl.: H01L 31/052, H01L 31/058

(54) **Concentrated photovoltaic/quantum well thermoelectric power source**

(30) Priority: 03.05.2012 US 201213463393
(71) Applicant: Hamilton Sundstrand Space Systems International, Inc., Windsor Locks, CT 06096 (US)
(72) Inventor: Lu, Cheng-Yi, West Hills, CA California 91307-3812 (US)
(74) Representative: Bridge, Kerry Ann

(57) **Abstract**

A solar power source 10 is a multi-layer structure consisting of photovoltaic 16 and quantum well thermoelectric modules 18 in electrical contact with, but thermally insulating from, each other. The structure generates power when focused solar energy is directed at the photovoltaic module 16 which generates power, heats up, and subsequently generate a thermal gradient in the thermoelectric module 18 which generates additional power. The thermoelectric module 18 may generate additional electrical energy using the Seebeck effect, or may cool the photovoltaic module 16 using the Peltier effect.

## Description

The present invention relates to solar power. In particular, the invention is concerned with efficient energy conversion using focused solar energy and a combined photovoltaic and quantum well thermoelectric conversion module.

### BACKGROUND

Common passive sources of power for space applications include solar photovoltaic, solar thermal dynamic, radioisotope, nuclear reactor, and fuel cell. A common power supply for low earth orbit missions utilizes photovoltaic systems. Since the energy output of a photovoltaic solar cell is directly proportional to the area of the cell, the actual areas of space-borne photovoltaic power systems can be quite large. From efficiency and weight considerations, it is advantageous to minimize the area of photovoltaic power supplies while maximizing power output. Solar cells with increased photovoltaic conversion efficiencies can reduce the size of solar cell arrays. However, although efficiencies of 30% are now available in commercial material, the increase only moderately affects the size of solar cell arrays currently satisfying mission requirements. Solar cell output can be increased with focused solar input. Increasing the intensity of incident solar radiation can be offset, however, by the decreased conversion efficiency accompanying the increased solar cell temperature.

Compact efficient solar power sources will be helpful additions for space based applications.

### SUMMARY

A method of converting solar energy into electrical energy consists of focusing solar energy to produce concentrated solar energy and generating electrical energy by directing the focused solar energy at a photovoltaic device. By transmitting the heat generated in the photovoltaic device into a thermoelectric device through an electrically insulating and thermally conducting layer, a thermal gradient between the photovoltaic device temperature and a heat exchanger exposed to outer space is established. In one embodiment, the thermoelectric device generates additional electrical energy using the Seebeck effect. In another embodiment, the thermoelectric device is operated as a Peltier refrigerator to cool the photovoltaic device to improve its electrical conversion efficiency.

A composite concentrated photovoltaic/thermoelectric power source is composed of a focusing lens module for concentrating incident solar radiation, a photovoltaic module for transforming incident concentrated solar radiation into electrical power, a thermoelectric module for converting heat transmitted from the photovoltaic module into electrical power, and a heat sink in contact with the thermoelectric module. Heat resulting from the concentrated solar radiation incident on the photovoltaic module is transmitted to the thermoelectric module via a thermally conducting and electrically insulating layer between the photovoltaic and thermoelectric modules and in contact with both.

In one embodiment, a thermal gradient in the thermoelectric module between the photovoltaic module and the heat sink generates electrical energy by the Seebeck effect. In another embodiment, the photovoltaic module powers the thermoelectric module as a Peltier refrigerator that cools the photovoltaic module to improve its electrical conversion efficiency.

### BRIEF DESCRIPTION OF THE DRAWINGS

FIG. 1 is a schematic of a composite solar photovoltaic/thermoelectric power source.

FIG. 2 is a plot of the efficiency of a commercial solar cell for space applications as a function of the incident solar concentration ratio.

FIG. 3 is a schematic showing a larger view of the photovoltaic and thermoelectric modules of FIG. 1.

FIG. 4 is a schematic showing an embodiment in which the thermoelectric module generates electrical energy by the Seebeck effect.

FIG. 5 is a schematic showing an embodiment in which the thermoelectric module cools the photovoltaic module by the Peltier effect.

### DETAILED DESCRIPTION

The present invention is a combined concentrated photovoltaic (CPV) and thermoelectric (TE) power source for remote power generation, particularly for providing power to spaceborne satellite systems. The solar photovoltaic power source converts solar energy into electrical energy via the photovoltaic effect. In one embodiment, the thermoelectric power source converts thermal energy from the solar photovoltaic power source into electrical energy via the Seebeck effect. The solar photovoltaic power source is proximate the thermoelectric power source and both add power to the system. In another embodiment of the invention, a portion of the electrical energy from the solar photovoltaic power source is used to activate the thermoelectric power source as a Peltier refrigerator to cool the photovoltaic power source thereby increasing its electrical conversion efficiency.

Incident solar energy is focused on the power source and is concentrated by focusing with a lens system. The focused solar radiation heats the photovoltaic component, which in turn heats the thermoelectric (TE) component and increases the thermal gradient of the thermoelectric component generating additional electric energy. Maximizing solar energy input to the CPV component and thermal gradient in the TE component maximizes energy output of the combined CPV/TE device of the invention. As discussed below, although photovoltaic conversion efficiency decreases as solar cell temperature increases, the temperature of the solar cell can be controlled by thermoelectric cooling in one embodiment of the invention.

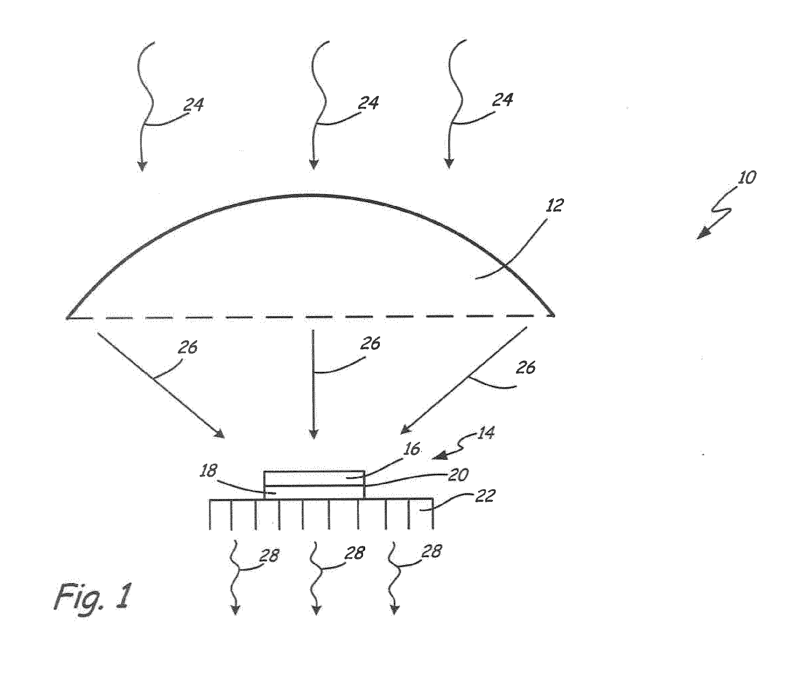

FIG. 1 shows composite solar photovoltaic/thermoelectric power source 10 comprising lens module 12, energy conversion module 14, and cooling module 22. Lens module 12 comprises a lens array (not shown) that focuses solar energy represented by wavy arrows 24 into concentrated solar energy represented by arrows 26 onto energy conversion module 14. Energy conversion module 14 comprises photovoltaic module 16 in contact with and separated from thermoelectric module 18 by electrically insulating and thermally conductive layer 20. Thermoelectric module 18 is connected to cooling fin structure 22 which radiates thermal energy represented by wavy arrows 28. In an embodiment of the invention, cooling structure 22 is radiating energy to outer space.

Within limits, the power output of a photovoltaic system can be increased by increasing the intensity of incident solar radiation. Lens module 12 performs that function in the present invention. Solar focusing lenses in lens module 12 may be refractive or reflective. An example of a refractive lens system is taught in U.S. Patent Nos. 6,075,200, 6,031,179, and 4,069,812, and incorporated herein as reference. The lens system is a lightweight, stretched, transparent, polymeric Fresnel lens with linear sections having prismatic cross sections of a design known in the art to provide a line focus of incident solar radiation to a receiver or a receiver array such as energy conversion module 14 in FIG. 1. Other lightweight focusing refractive lens systems known to those in the art may also be used. An example of a reflective lens is taught in U.S. Pat. Nos. 4,719,903; 5,865,905; and 5,202,689, and incorporated herein as reference. The reflective lens system is a lightweight reflective parabolic trough with an adjustable line focus. Other lightweight focusing reflective lens systems known to those in the art may also be used.

CPV module 16 (i.e. solar cell) receives concentrated solar energy 26 and transforms it to electrical energy by the photovoltaic effect. As known in the art, the fundamental mechanism of photovoltaic energy conversion comprises the solar generated formation of electrons, holes, and associated internal electric fields in semiconductor pn junctions that results in a photo current in a completed circuit. Developments over the last four decades have resulted in multi-junction solar cells with maximum conversion efficiencies exceeding 40% in terrestrial CPV application. Solar cells with efficiencies exceeding 25% are commercially available for use in the claimed embodiments of the invention. Solar photovoltaic power sources are generally available in the industry. While not limited to any photovoltaic material or device known in the art, solar cells suitable for embodiments of the present invention may be 29.5% efficient NeXt Triple Junction (XTJ) solar cells, and 28.3% efficient Ultra Triple Junction (UTJ) solar cells produced by Spectrolab, Inc., Sylmar, CA, and 29.5% efficient Minimum Average Efficiency Triple Junction Solar Cells and 33% efficient inverted metamorphic multifunction (IMM) solar cells produced by Emcore Co., Albuquerque, N.M.

Concentrated solar energy directed at CPV module 16, as noted above, increases the temperature of CPV module 16, thereby establishing a thermal gradient in TE module 18. The thermal gradient results from thermal energy crossing electrically insulating and thermally conducting layer 20 between CPV module 16 and TE module 18. While not limited to any electrically insulating and thermally conducting materials known in the art for layer 20, preferred materials include aluminum nitride, aluminum oxide, carbon-carbon composite, polyimide or polymeric materials.

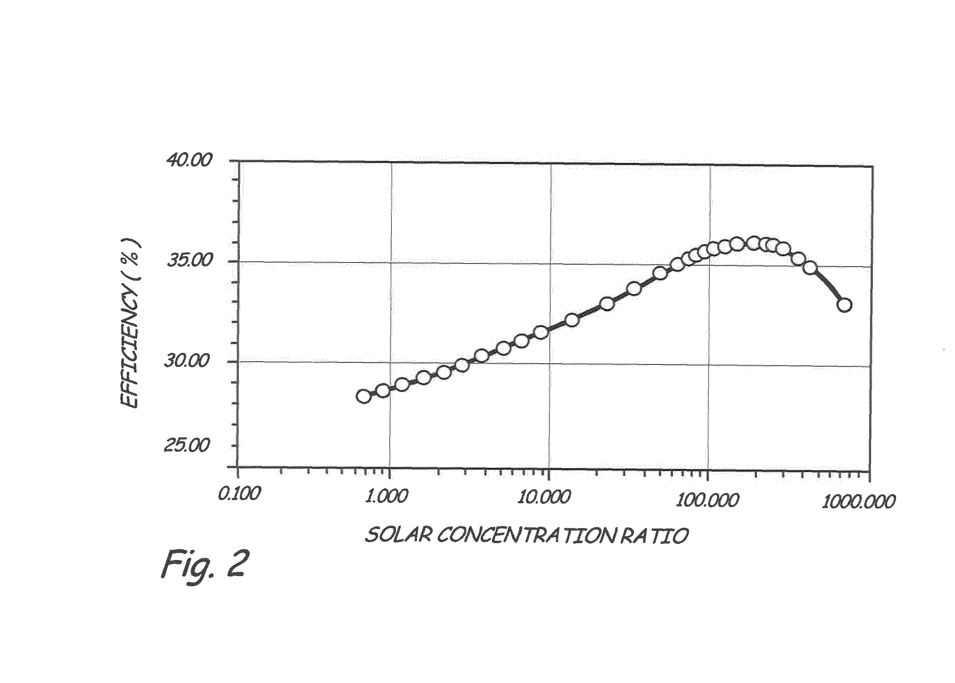

A preferred source is Spectrolab Triple Junction XTJ solar cells. The conversion efficiency of a Spectrolab, XTJ solar cell is shown in FIG. 2 as a function of incident solar radiation in space. At an incident radiation intensity of 10 suns, the efficiency is approximately 34%.

The origin of thermoelectricity lies in the well known Seebeck and Peltier effects. The Seebeck effect occurs when dissimilar materials are joined in junctions held at different temperatures. A voltage difference develops that is proportional to the temperature difference. The Peltier effect occurs when a current is passed through the junction of two dissimilar materials. Heat is either absorbed or ejected from the junction depending on the direction of the current. The two effects are related.

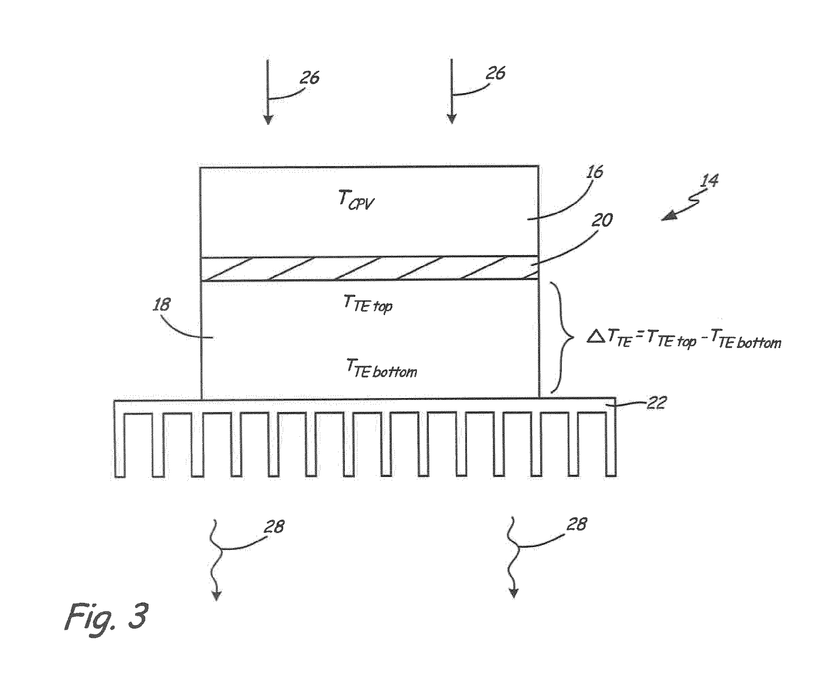

The operation of power source 10 relies on concentrated solar radiation 26 from lens module 12 to generate photo induced electric energy P_{CPV} in CPV module 16. A schematic of a larger view of energy conversion module 14 is shown in FIG. 3. The temperature of CPV module 16 is T_{CPV} as indicated in FIG. 3. The temperature of TE module 18 increases as thermal energy flows through electrically insulating and thermally conducting layer 20 from CPV module 16 to TE module 18. The interface temperature is T_{TEtop} as indicated in FIG. 3. Temperature at the interface in contact with cooling structure 22 is T_{TEbottom}. A thermal gradient ΔT = T_{TEtop} - T_{TEbottom} is maintained that results in thermoelectric power P_{TE} generated by TE module 18, In this embodiment of the invention, the net power from power source 10 is Pₙₑₜ = P_{CPV} + P_{TE}.

Increasing concentrated solar energy input 26 to energy conversion module 14 increases power output, but at a cost. The conversion efficiency of a photovoltaic source decreases as its temperature increases resulting in a finite operating temperature range for efficient cooling. In another embodiment of the invention, TE module 18 can be used as a refrigerator to cool CPV module 16 to boost conversion efficiency. In this embodiment, a portion of the electrical power from CPV module 16 is used to power TE module 18 in a Peltier cooling mode wherein heat is extracted from CPV module 16 at the interface and is rejected to cooling structure 22. As a result, the power output of CPV module 16 will improve. The relative efficiencies of both embodiments of the invention are discussed below.

The potential of a material for thermoelectric applications is related to the material's thermoelectric figure of merit ZT. ZT=α²σT/K where α is the Seebeck coefficient, σ the electrical conductivity, T the temperature, and K the thermal conductivity. K is the sum of the lattice vibration (phonons) contribution, K_{L} and electronic contribution, K_{E}, of the thermal conductivity or K=K_{L}+K_{E}.

Maximizing the performance for both embodiments of the invention requires maximizing ZT. Seebeck coefficients are intrinsic material properties and most development effort has been on minimizing K. Since the electrical conductivity σ is related to the electronic thermal conductivity K_{E} through the Wiedemann-Franz relationship and the ratio σ/K is essentially constant at a given temperature, most efforts to improve thermoelectric efficiency focus on decreasing lattice thermal conductivity, K_{L}.

Optimum ZT values for bulk thermoelectric materials rarely exceed unity. However, over the past decade, quantum well superlattice multi-layer thermoelectric structures with alternating n and p layers having layer separations on the order of 100 nanometers have been developed with ZT values exceeding unity and conversion efficiencies exceeding 10%. The predominant mechanism behind the improved thermoelectric performance is suggested to be decreased phonon mobility due to interaction with the layers and interfaces of the quantum well superlattice structure. In addition, the physical restriction to phonon propagation in low dimensional quantum well and quantum dot features of quantum well and quantum dot superlattice thermoelectric material systems are suggested to enhance the electronic properties while impeding thermal migration.

A number of thermoelectric materials known in the art may be used in thermoelectric module 18 of solar power source 10. In an embodiment of the invention, high performance quantum well superlattice thermoelectric materials with conversion efficiencies exceeding 10% are used in TE module 18. While not limited to any thermoelectric material or device known in the art, a preferred material comprises a quantum well superlattice structure of alternating 5 to 10 nanometer thick layers and at least a a total of 100 alternating layers of p type B₉C/B₄C layers for the p legs and n type Si/SiGe layers for the n legs. Another preferred high performance thermoelectric material for TE module 18 comprises a quantum well superlattice structure with alternating 5-10 nanometer thick layers and at least a a total of 100 alternating layers of p doped Si/SiGe layers for the p legs and n doped SilSiG layers for the n legs. Both materials are commercially available from Hi-Z Technology, Inc., San Diego, CA, and are described in U.S. Pat. Nos. 7,400,050; 6,828,479; 5,095,954; and 5,436,467, which are incorporated by reference herein. The thermoelectric efficiencies of both quantum well superlattice structure materials have been confirmed by Hi-Z Technology to be about 14%.

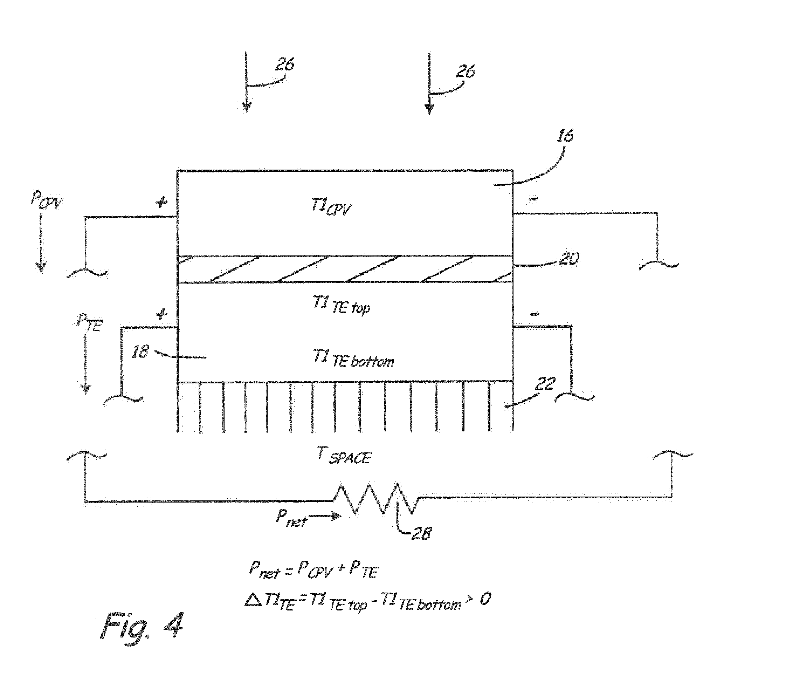

A schematic showing the operation of an embodiment wherein the output of CPV module 16 and TE module 18 are combined is shown in FIG. 4. The outputs of CPV module 16 and TE module 18 are P1_{CPV} and P1_{TE}, respectively. The net power output, P1ₙₑₜ is P1ₙₛₜ = P1_{CPV} + P1_{TE}. The thermal gradient across TE module 18 is ΔT1_{TE} = T1_{TEtop} - T1_{TEbottom} > 0.

In this embodiment, the CPV and TE modules are wired in series to obtain maximum output. Other electrical connections are possible. The temperature gradient T1_{TEtop} -T1_{TEbottom} in TE module 18 is positive as a result of positive heat flow from CPV module 16 into TE module 18. As noted earlier, the conversion efficiency of CPV module 16 decreases as T1_{CPV} increases. As a result, increasing concentrated solar input 16 to increase P_{CPV}, the power output from CPV module 16, is limited by the resulting temperature increase in T1_{CPV}.

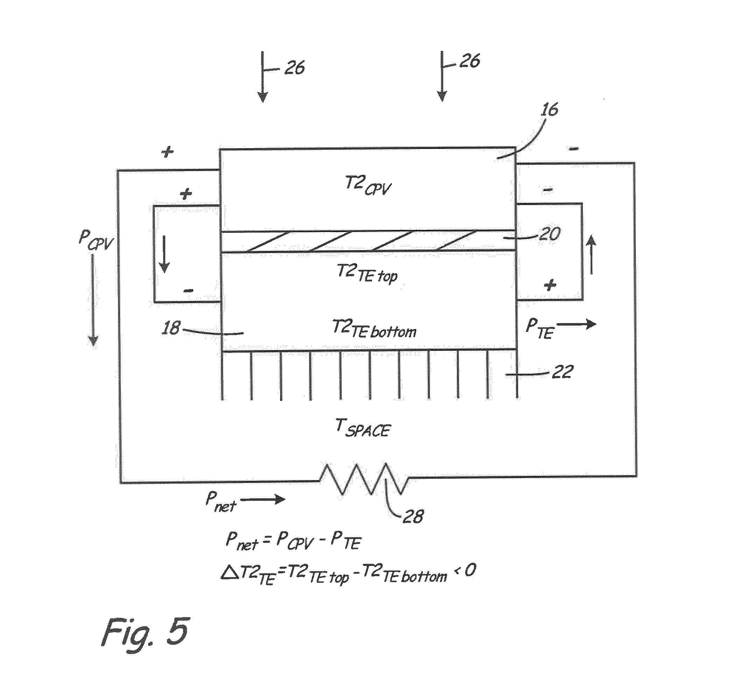

An embodiment to address the loss of conversion efficiency of CPV module 16 due to overheating is shown in the schematic of FIG. 5. In FIG. 5, TE module 18 functions as a Peltier refrigerator. A portion of the power output from CPV module 16 is used to power TE module 18 and cool the interface between CPV module 16 and TE module 18. The temperature gradient across TE module 18, ΔT2_{TE} = T2_{TEtop} - T2_{TEbottom} < 0 is negative and acts to cool CPV module 16. In this embodiment, T2_{CPV} is less than T1_{CPV} in the first embodiment and the conversion efficiency of cooled CPV module 16 in the second embodiment exceeds the conversion efficiency of CPV module 16 in the first embodiment.

Cooling a concentrated photovoltaic (CPV) solar power source by a quantum well thermoelectric (QWTE) power source that is, in turn, powered by the photovoltaic power source to improve the efficiency of the hybrid CPV/QWTE power source is only possible because of the high conversion efficiencies exhibited by the modem CPV and QWTE materials used.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A method of converting solar energy into electrical energy by a power source (10) comprising:
focusing incident solar energy to produce concentrated solar energy;
generating electrical energy from the concentrated solar energy by a photovoltaic effect, the electrical energy being generated by focusing the concentrated solar energy on a photovoltaic module (16); and
transmitting heat produced by the concentrated solar energy to a thermoelectric module (18).

2. The method of claim 1, further comprising using a portion of the transmitted heat received by the thermoelectric module to generate additional electrical energy by a Seebeck effect.

3. The method of claim 2, further comprising combining the additional generated electrical energy with a portion of the electrical energy to form a net power output.

4. The method of claim 1, further comprising cooling the photovoltaic module (16) by a Peltier effect and transferring heat from the thermoelectric module (18) to a heat sink.

5. The method of claim 4, further comprising using a portion of the electrical energy to power the thermoelectric module (18) as a Peltier refrigerator to cool the photovoltaic module (16) and increase photovoltaic power output,

6. The method of claim 4, wherein the thermoelectric device comprises at least one of a quantum well superlattice structure comprising alternating 5-10 nanometer thick layers and at a least total of 100 alternating layers of p type B₉C /B₄C and n type Si/SiGe and comprising alternating 5-10 nanometer thick layers and at least a total of 100 alternating layers of p doped Si/SiGe and n doped Si/SiGe.

7. The method of claim 1, further comprising using a reflective or refractive lens system as the lens focusing device.

8. A composite concentrated photovoltaic/thermoelectric power source (10) comprising:
a focusing lens module (12) for concentrating incident solar radiation;
a photovoltaic module (16) with a first surface for transforming incident concentrated solar radiation from the lens module into electrical power;
a thermoelectric module (18) with a second surface receiving heat transmitted from the photovoltaic module (16);
a thermally conducting and electrically insulating layer (20) with a top surface in contact with the first surface of the photovoltaic module (16) and a bottom surface in contact with the second surface of the thermoelectric module (18); and
a heat sink in contact with the thermoelectric module.

9. The composite power source of claim 8, wherein the electrical power output from the thermoelectric module (18) produced by a Seebeck effect is added to the photovoltaic power output of the photovoltaic module to increase the overall electrical power output of the power source (10).

10. The composite power source of claim 8, wherein the thermoelectric module is used as a Peltier refrigerator to decrease a temperature of the photovoltaic module thereby increasing the photovoltaic power output.

11. The method of claim 1 or the composite power source of claim 8, wherein the thermoelectric device comprises a quantum well superlattice thermoelectric device.

12. The composite power source of claim 11, wherein the thermoelectric module comprises at least one of a quantum well superlattice structure of alternating 5-10 nanometer thick layers and at least a total of 100 alternating layers of p type B₉C/B₄C and n type Si/SiGe and 5-10 nanometer thick layers and at least a total of 100 alternating layers of p doped Si/SiGe and n doped Si/SiGe.

13. The method of claim 1 or the composite power source of claim 8, wherein the photovoltaic module (16) has a conversion efficiency greater than 25%.

14. The composite power source of claim 8, wherein the focusing lens module comprises a reflective or refractive lens system.

15. The method of claim 1 or the composite power source of claim 8, wherein the electrically insulating, thermally conducting layer is selected from the group consisting of aluminum nitride, aluminum oxide, carbon-carbon composite, polymide, or polymeric materials.
